# EUROPEAN PATENT APPLICATION

(11) **EP 2 822 044 A1**
(43) Date of publication of application: **07.01.2015**
(21) Application number: 12869686.1
(22) Date of filing: 28.02.2012
(51) Int. Cl.: H01L 31/18, H01L 31/05

(54) **METHOD FOR ELIMINATING AND DEVICE FOR ELIMINATING CONDUCTOR MEMBER CURL**

(71) Applicant: Fuji Machine Mfg. Co., Ltd., Chiryu-shi Aichi 472-8686 (JP)
(72) Inventor: IWAKI Noriaki, Chiryu-shi Aichi 472-8686 (JP); HIRATA Shuichi, Chiryu-shi Aichi 472-8686 (JP)
(74) Representative: Grünecker, Kinkeldey, Stockmair & Schwanhäusser
(86) International application number: PCT/JP2012/054924
(87) International publication number: WO 2013/128570

(57) **Abstract**

A conductive member winding curl removal device and removal method which pulls out a conductive member wound around a bobbin at a predetermined acceleration and which can remove the winding curl of the conductive member. For this, provided are: a pulling out means 42 for clamping the end of and pulling out conductive member 12 wound around bobbin 41; a drawing means (58, 158) for drawing the conductive member with a force smaller than the force required to break the conductive member arranged between the pulling out means and the bobbin; and a moving means (46) for moving the pulling out means which clamped the end of the conductive member at a predetermined acceleration and pulling the conductive member against the drawing means.

## Description

### Technical Field

The present invention relates to a conductive member winding curl removal device and removal method which remove the winding curl from a conductive member pulled out from a bobbin.

### Background Art

Conventionally, for photovoltaic modules (solar panels) with multiple photovoltaic cells which have a negative electrode formed on the light receiving surface and a positive electrode on the reverse side arranged horizontally and vertically, interconnectors are used to string together the multiple photovoltaic cells. In other words, interconnectors are used to perform stringing by connecting together an electrode of one photovoltaic cell and an electrode of an adjacent photovoltaic cell. As an example of this type of photovoltaic module, that disclosed in patent literature 1 is known.

### Citation List

### Patent Literature

Patent Literature 1: Japanese Unexamined Patent Application Publication Number 2003-298095

### Summary of Invention

### Problem to be Solved by the Invention

For this type of photovoltaic module manufacturing device, interconnectors wound around a bobbin are pulled out, cut to a predetermined length and then joined to a photovoltaic cell; however, because the interconnector wound around the bobbin has winding curl, there are concerns that the interconnectors cannot be joined reliably to the photovoltaic cells if the joining strength with the photovoltaic cell is not sufficient.

The present invention is an item which solves the above current problems whose object is a conductive member winding curl removal device and removal method which pulls out a conductive member wound around a bobbin at a predetermined acceleration and which can remove the winding curl of the conductive member.

### Means for Solving the Problem

The present invention comprises: a pulling out means for clamping the end of and pulling out a conductive member wound around a bobbin; a drawing means for drawing the conductive member with a force smaller than the force required to break the conductive member arranged between the pulling out means and the bobbin; and a moving means for moving the pulling out means which clamped the end of the conductive member at a predetermined acceleration and pulling the conductive member against the drawing means.

With this kind of configuration, the pulling out means which clamped the end of the conductive member drawn out by the drawing means is moved at a predetermined acceleration, the winding curl of the conductive member with winding curl which is wound around the bobbin can be removed and the photovoltaic cells and conductive members can be joined accurately.

### Brief Description of Drawings

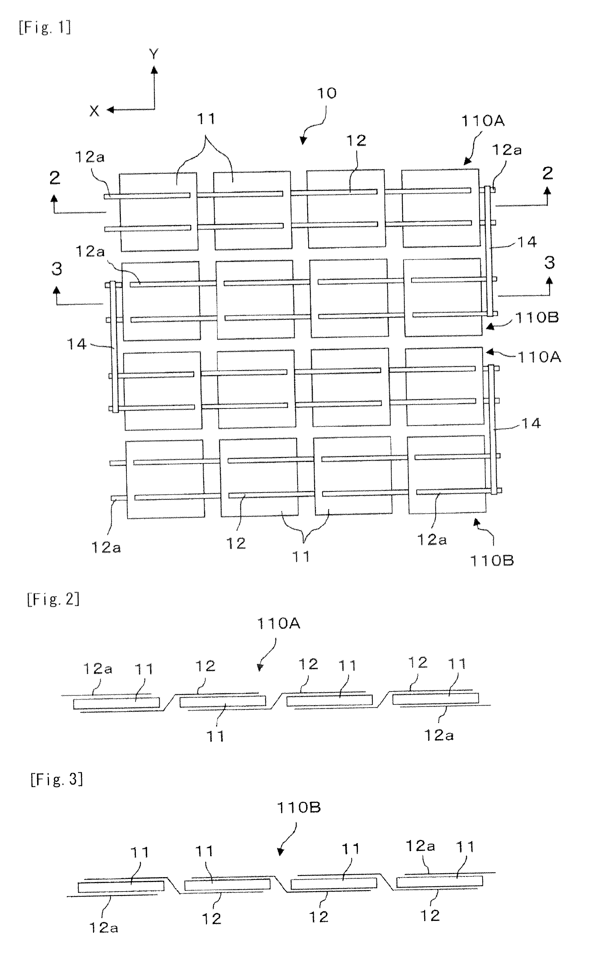

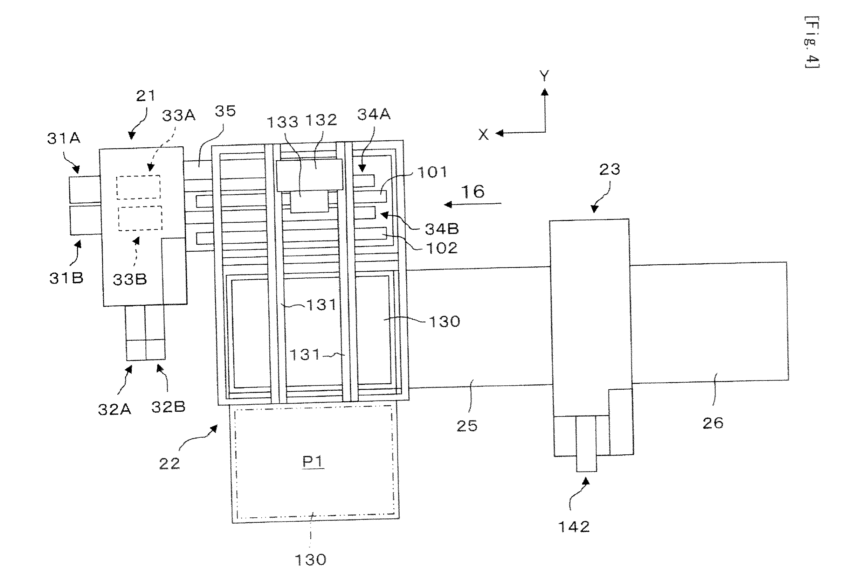

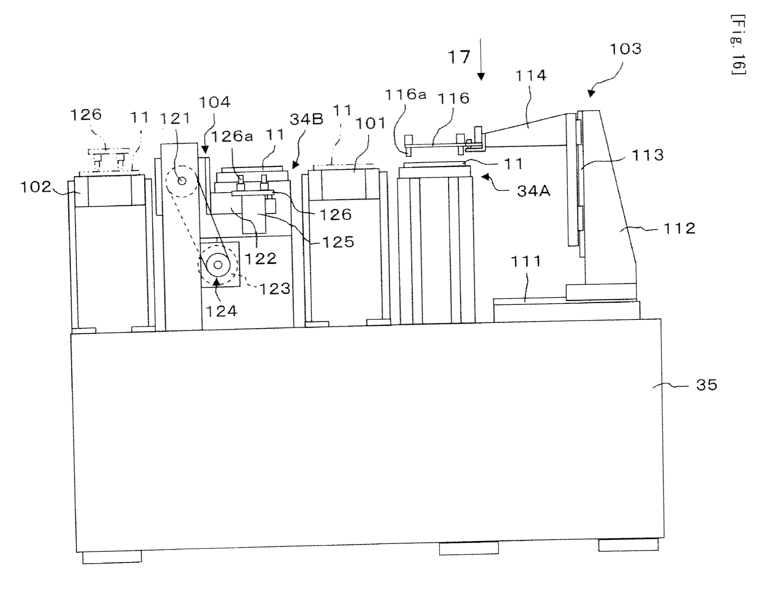

[FIG. 1]
   This is an outline top view showing a photovoltaic module.
[FIG. 2]
   This is a cross section view along line 2-2 of FIG. 1.
[FIG. 3]
   This is a cross section view along line 3-3 of FIG. 1.
[FIG. 4]
   This is a top view showing the overall photovoltaic module manufacturing device of an embodiment of the present invention.
[FIG. 5]
   This is an outline side view showing the connector supply unit of the stringing device.
[FIG. 6]
   This is illustration of cutting the interconnectors to a predetermined length and then drawing out.
[FIG. 7]
   This is an outline top view showing the cell supply unit of the stringing device.
[FIG. 8]
   This is an illustration showing the photovoltaic cell supply procedure of the cell supply unit.
[FIG. 9]
   This is a top view showing a photovoltaic cell with flux applied.
[FIG. 10]
   This is an outline top view showing the carrier head of the cell supply unit.
[FIG. 11]
   This is a top view showing the joining units of the stringing device.
[FIG. 12]
   This is a drawing showing the retainer member provided on the upper section hot plate of the joining unit.
[FIG. 13]
   This is a drawing showing the interconnectors and photovoltaic cells layered on the joining unit.
[FIG. 14]
   This is a drawing showing the conveyance members of the cell conveyance unit of the stringing device.
[FIG. 15]
   This is an outline top view showing the slow cooling station of the cell conveyance unit.
[FIG. 16]
   This is a drawing showing the cell conveyance unit as viewed from the direction of arrow 16 of FIG. 4.
[FIG. 17]
   This is a drawing of the view from the direction of arrow 17 of FIG. 16.
[FIG. 18]
   This is a perspective view showing the matrixing device.
[FIG. 19]
   This is a schematic drawing showing the interconnector winding curl removal device of an alternative embodiment of the present invention.

### Description of Embodiments

The following describes a photovoltaic cell stringing device and photovoltaic module manufacturing device of an embodiment of the present invention.

FIG. 1 is an outline view showing an example of photovoltaic module (solar panel) 10; photovoltaic module 10 comprises multiple (Xm cells in the X direction and Yn lines in the Y direction which is orthogonal to the X direction) photovoltaic cells 11 arranged flat in the XY direction and electrically connected in series. FIG. 1, for ease of understanding, shows an example of photovoltaic module 10 constructed from four cells Xm and 4 lines Yn making a total of sixteen photovoltaic cells 11.

Photovoltaic cells 11 connected in the X direction are electrically connected via interconnector 12 as a conductive member. Interconnector 12 is an item in a straight line which has a length in the X direction straddling two adjacent photovoltaic cells 11, and, as shown in FIG. 2 and FIG. 3, the right edge (front half) of the lengthways direction thereof is joined to the negative electrode formed in the lower surface (light receiving surface) or the positive electrode formed in the upper surface (reverse surface) of photovoltaic cell 11, and the left edge (latter half) of the lengthways direction thereof is joined to the positive electrode formed in the upper surface of photovoltaic cell 11 or the negative electrode formed in the lower surface.

On photovoltaic cells 11 arranged at both ends in the X direction, interconnectors 12a which are shorter than interconnectors 12 with a length straddling two photovoltaic cells 11 are joined to the lower surface (negative electrode) or upper surface (positive electrode) of photovoltaic cells 11. Each end of those short interconnectors 12a protrude slightly from both ends of photovoltaic cells 11.

By this, the required quantity Xm of photovoltaix cells 11 arranged in the X direction are electrically connected in series to form strung photovoltaic cell groups 110A and 110B. Additionally, the required quantity of lines Yn of those photovoltaic cell groups 110A and 110B are arranged in the Y direction, and photovoltaic module 10 is formed by matrixing the corresponding short interconnectors 12a.

Here, in the odd numbered rows of photovoltaic cell groups 110A as seen from above in FIG. 1, as shown in FIG. 2, each end of short interconnectors 12a protrudes slightly from the upper surface and lower surface of photovoltaic cells 11 at the left and right ends; while in the even numbered rows of photovoltaic cell groups 110B as seen from above in FIG. 1, as shown in FIG. 3, each end of short interconnectors 12a protrudes slightly from the lower surface and upper surface of photovoltaic cells 11 at the left and right ends.

In this way, photovoltaic module 10 is formed from two types of photovoltaic cell groups 110A and 110B (hereafter referred to as number 1 photovoltaic cell group 110A and number 2 photovoltaic cell group 110B) with different interconnector 12 joining constructions, with these number 1 and number 2 photovoltaic cell groups 110A and 110B arranged alternately in the Y direction.

Additionally, each end of interconnectors 12a protruding from both end sections of odd numbered number 1 photovoltaic cell group 110A and each end of interconnectors 12a protruding from both end sections of even numbered number 2 photovoltaic cell group 110B are joined to each other as shown in FIG. 1 by busbar 14 which is used as a conductive member, whereby all photovoltaic cells 11 which go to form photovoltaic module 10 are connected in series.

Generally photovoltaic modules 10 are completed products in which cover glass made from transparent toughened glass is arranged on the light receiving surface (negative electrode) and a back sheet with excellent weather resistance properties is arranged on the reverse surface (positive electrode), and multiple photovoltaic cells 11 are sealed between the cover glass and back sheet using a resin such as EVA; however, for the embodiment below, for convenience of description, Xm x Yn photovoltaic cells 11 arranged on the cover glass are referred to photovoltaic module 10.

Next, the following describes the detailed configuration of the manufacturing device for manufacturing photovoltaic modules 10 with the configuration outlined above. The manufacturing device, as shown in FIG. 4, comprises stringing device (stringing process) 21, layup device (layup process) 22, and matrixing device (matrixing process) 23 arranged along the X direction. Layup device 22 and matrixing device 23 are connected by conveyor 25, and photovoltaic modules 10 wired together in a matrix by matrixing device 23 are conveyed to the next process by conveyor 26.

In order to wire together number 1 and number 1 photovoltaic cell groups 110A and 110B in a matrix, stringing device 21 comprises mainly of two connector supply units (conductive member supply units) 31 A and 31 B for supplying interconnectors 12, two cell supply units 32A and 32B for supplying photovoltaic cells 11, two joining units 33A and 33B for joining interconnectors 12 to photovoltaic cells 11, and two rows of cell conveyance units 34A and 34B for conveying photovoltaic cells 11 to which interconnectors 12 have been joined, and these sets (two rows) of two units are arranged in parallel to each other.

These connector supply units 31 A and 31B, cell supply units 32A and 32B, joining units 33A and 33B, and cell conveyance units 34A and 34B are arranged on shared base 35. Below, each set of units for manufacturing number one photovoltaic cell group 110A is referred to as unit one and each set of units for manufacturing number two photovoltaic cell group 110B is referred to as unit two for distinguishing purposes.

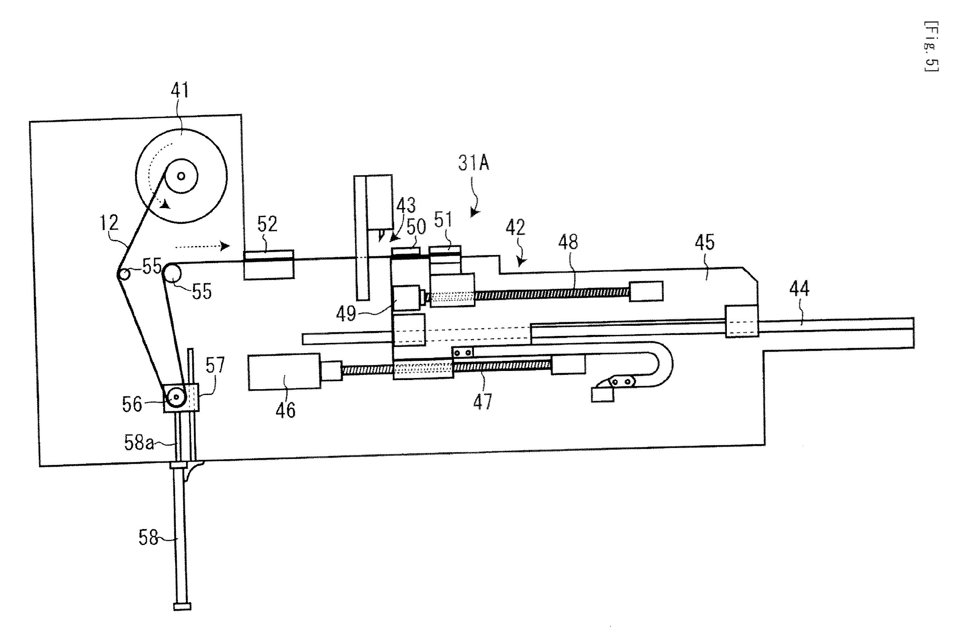

The number one connector supply unit 31A, as shown in FIG. 5, comprises multiple rows (in the embodiment, two rows) of bobbin 41 separated in the Y direction around which is wound interconnector 12, pulling out means 42 for clamping each end of interconnector 12 wound around bobbin 41 and pulling it in the X direction, and up/down movable cutter 43 for cutting to a predetermined length interconnector 12 which has been pulled by pulling out means 42 to a predetermined position.

Pulling out means 42 has a moving platform 45 movably attached to guide rail 44 which is formed in the X direction, and moving platform 45 is moved a predetermined amount in the X direction along guide rail 44 by the rotation of number one ball screw axis 47 which is rotated by motor 46.

On moving platform 45, number two ball screw axis 48 is rotatably attached around an axis line parallel to number one ball screw 47, and number two ball screw axis 48 is rotated by motor 49 provided on moving platform 45. Also, moving guide 50 for guiding interconnectors 12 is fixed to moving platform 45.

Number one and number two clampers 51 and 52 which clamp interconnectors 12 pulled from bobbin 41 are provided on pulling out means 42, and number one and number two clampers 51 and 52 are capable of clamping and unclamping interconnectors 12 by the operation of an actuator which has been omitted from the drawing. Number one clamper 51 is located in a position downstream from cutter 43 and number two clamper 52 is located in a position upstream from cutter 43.

Number one clamper 51 is engaged with number two ball screw axis 48 and can be moved a predetermined amount in the X direction after clamping the end of interconnector 12. On the other hand, number two clamper 52 is provided such that it is advanced a predetermined amount in the X direction by a cylinder not shown in the drawing, so that when interconnector 12 is cut to a predetermined length it clamps the base portion of interconnector 12 to be cut.

Interconnector 12 pulled from bobbin 41 is pulled while being guided along multiple guide rollers 55. In a position below and between multiple guide rollers 55, engagement roller 56 is provided on raising/lowering member 57 which can move up and down, and interconnector 12 is wrapped around this engagement roller 56 and bent into a U-shape and guided by fixed number two clamper 52.

Guide roller (downstream guide roller) 55 which is downstream to engagement roller 56 is shared by multiple interconnectors 12 which are to be joined to photovoltaic cells 11, and the outer surface thereof is provided with multiple grooves aligned with the joining position in the Y direction of interconnector 12 for multiple types of photovoltaic cells 11. By this, when interconnector 12 is pulled from bobbin 41, even when it is pulled from bobbin 41 and the position moved in the Y direction, when it is pulled around the downstream roller, it is definitely aligned with the joining interval in the Y direction of interconnector 12. Further, because grooves aligned with the joining interval in the Y direction of each interconnector 12 for multiple types of photovoltaic cells 11 are provided in advance, it is easy to change production to differing photovoltaic cells 11. Also, interconnector 12 is pulled by downstream guide roller 55 at an acute angle in the opposite direction to the winding curl direction of bobbin 41.

Piston rod 58a of tension cylinder 58 is connected to raising/lowering member 57, and tension cylinder 58 draws interconnector 12 via raising/lowering member 57 with a tensile force smaller than the power required to break interconnector 12. The drawing means for drawing interconnectors 12 with a force smaller than that required to break them comprises the tension cylinder 58; and the moving means comprises items such as motor 46 for moving moving platform 45. The tensile force of tension cylinder 58 can be changed in accordance with the type (power required to break) of interconnector 12.

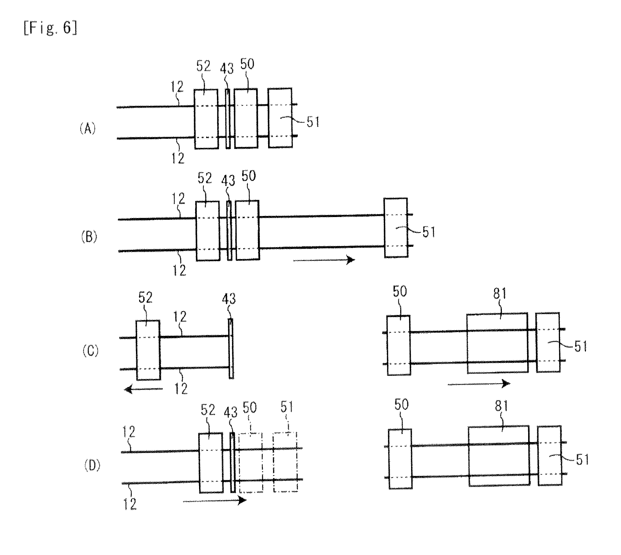

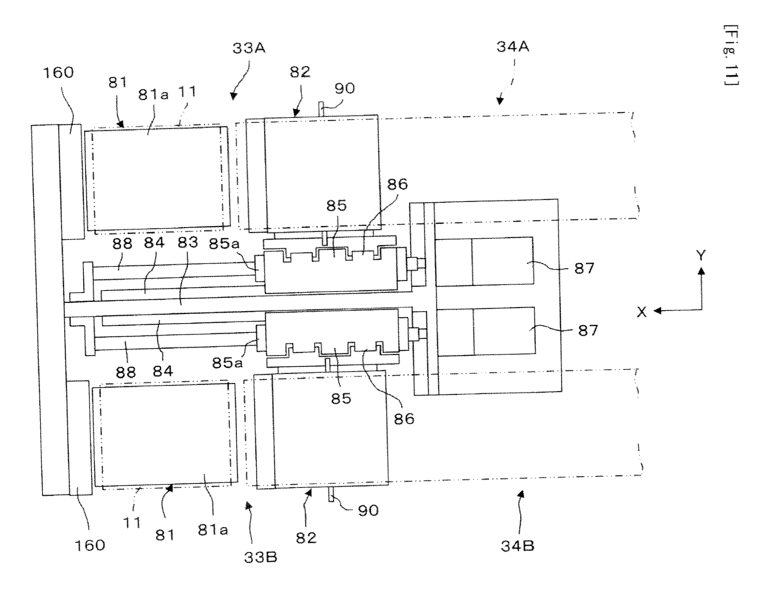

The means for cutting to a predetermined length interconnectors 12 pulled by bobbin 41 of number 1 connector supply unit 31A and supplying them onto photovoltaic cell 11 loaded on lower section hot plate 81 (refer to FIG. 11) of number 1 joining unit 33A is shown in FIG. 6. First, from the initial position shown by FIG. 6 (A), by rotating number two ball screw axis 47 by a predetermined amount using number two motor 49, number one clamper 51 which has clamped an end of interconnectors 12 is advanced forward to a specified position and interconnectors 12 are pulled by a predetermined amount, as shown in FIG. 6 (B). Thereafter, cutter 43 is lowered and cuts interconnectors 12 to a predetermined length.

Next, by moving moving platform 45 a predetermined amount via the rotation of number one ball screw axis 47 using number one motor 46, number one clamper 51 is moved along with moving guide 50 as one with moving platform 45 (refer to FIG. 6 (C)). By this, number one clamper 51 is moved above lower section hot plate 81, and the predetermined length of interconnectors 12 which are clamped by this are supplied onto photovoltaic cell 11 loaded on lower hot plate 81.

At the same time, number two clamper 52 is unclamped and retracted a specified amount, and after that, with interconnectors 12 clamped by number two clamper 52, number two clamper 52 is advanced a specified amount and interconnectors 12 are pulled to cutter 43 front position (refer to FIG. 6 (D)). Along with this, number one clamper 51 is unclamped, and by number one clamper 51 being returned to its original position along with moving platform 45 by number one and number two motors 46 and 49 (refer to FIG. 6 (A)), interconnectors 12 are layered on photovoltaic cell 11.

Incidentally, when interconnectors 12 clamped by number one clamper 51 are pulled out by number two motor 49, by setting that movement acceleration appropriately (for example, 1 G), interconnectors 12 can be drawn against the tensile force of tension cylinder 58. By this, the winding curl of interconnectors 12 with winding curl which are wound around bobbin 41 can be removed and corrected to be straight. Here, because interconnectors 12 are being drawn by a tensile force smaller than the force required to break them, if the tensile force acting on interconnectors 12 becomes larger, raising/lowering member 57 is raised so that excess tensile force is not acted on interconnectors 12, and it is possible to remove the winding curl.

Number two connector supply unit 31B has the same configuration as the above number one connector supply unit 31 A, and cuts interconnectors 12 pulled by bobbin 41 to a predetermined length while removing the winding curl and supplies them onto photovoltaic cell 11 loaded on lower section hot plate 81 (refer to FIG. 11) of number two joining unit 33B.

Number one cell supply unit 32A orients photovoltaic cells 11 with the light receiving surface facing down and conveys them in the Y direction and is the item for supplying to number one joining unit 33A, and number two cell supply unit 32B orients photovoltaic cells 11 with the light receiving surface facing up and conveys them in the Y direction and is the item for supplying to number one joining unit 33B.

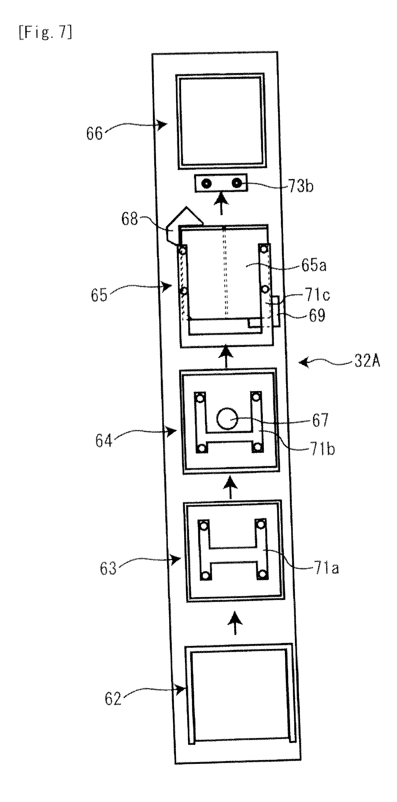

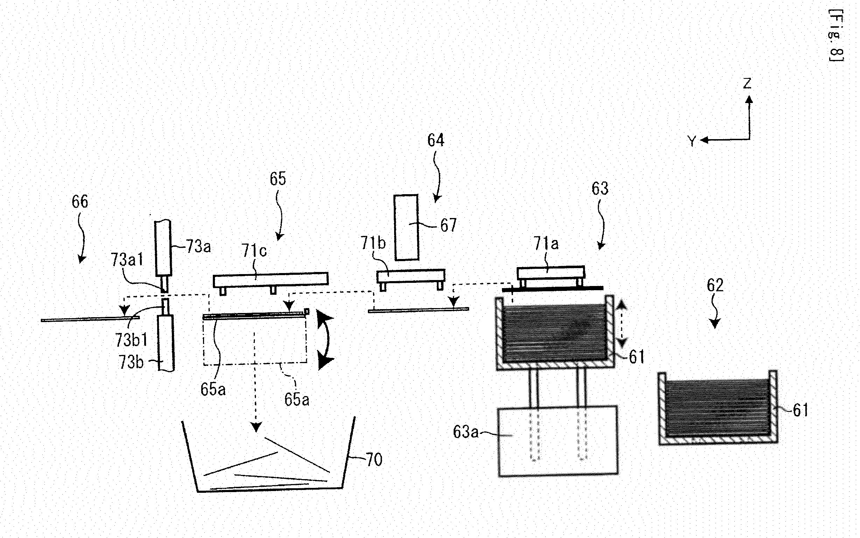

As shown in FIG. 7 and FIG. 8, cell supply station 62 for supplying cassettes 61 stacked with multiple photovoltaic cells 11 oriented with the light receiving surface facing down, cell lifter station 63 for holding constantly at a fixed height the uppermost photovoltaic cell 11 stacked in cassette 61, cell inspection station 64 for inspecting for chipped or broken photovoltaic cells 11, tilt correction station 65 for correcting the tilt of photovoltaic cells 11, and cell transfer station 66 for transferring photovoltaic cells 11 are arranged in number one cell supply unit 32A in the Y direction at fixed intervals.

Cassettes 61 supplied to cell supply station 62 are loaded manually or automatically onto lifter 63a of cell lifter station 63 and the uppermost photovoltaic cell 11 stacked in cassette 61 is held constantly at a fixed height by lifter 63a. In other words, the position of the upper surface of the uppermost photovoltaic cell 11 is detected using a height detection sensor not shown in the drawings so that even if stacked photovoltaic cells 11 are supply sequentially, the uppermost photovoltaic cell 11 can be constantly held at a fixed height.

Inspection camera 67 for capturing images of supplied photovoltaic cells 11 from above is provided on cell inspection station 64, and by processing images captured by inspection camera 67, it is possible to detect defects such as breakages or chips in photovoltaic cells 11.

At tilt correction station 65, the tilt of photovoltaic cells 11 is corrected by pushing supplied photovoltaic cells 11 against reference block 69 using pushing member 68. Also, opening/closing door 65a is provided on the underside of tilt correction station 65 in order to discard photovoltaic cells 11 on which a defect was detected by inspection camera 67, and waste box 70 is provided below opening/closing door 65a.

Photovoltaic cells 11 are conveyed consecutively and simultaneously by three cell transfer hands 71 a, 71 b, and 71c via a pick and place action from cell lifter station 63 to cell inspection station 64, from cell inspection station 64 to tilt correction station 65, and from tilt correction station 65 to cell transfer station 66. That is, cell transfer hands 71a, 71b, and 71c are provided on a hand device omitted from the drawings which is provided on cell supply unit 32A, and photovoltaic cells are picked up and held by cell transfer hands 71a, 71b, and 71c and conveyed consecutively to the next station by the pick and place movement of the hand device which is omitted from the drawings and which can be moved in the Y direction and up/down direction.

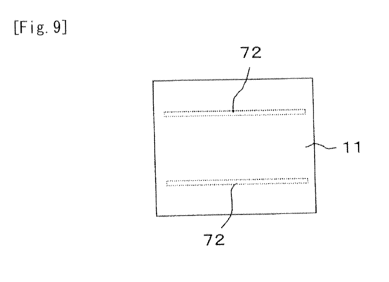

A total of four supply nozzles 73a1 and 73b1, two each upper and lower, of dispensers 73a and 73b for dispensing two rows of flux 72 (refer to FIG. 9) to the upper and lower surfaces respectively of photovoltaic cells 11 are provided between tilt correction station 65 and cell transfer station 66. Dispensers 73a and 73b apply flux to the upper and lower surfaces respectively of photovoltaic cells 11 conveyed to cell transfer station 66 from tilt correction station 65 by cell transfer hand 71.

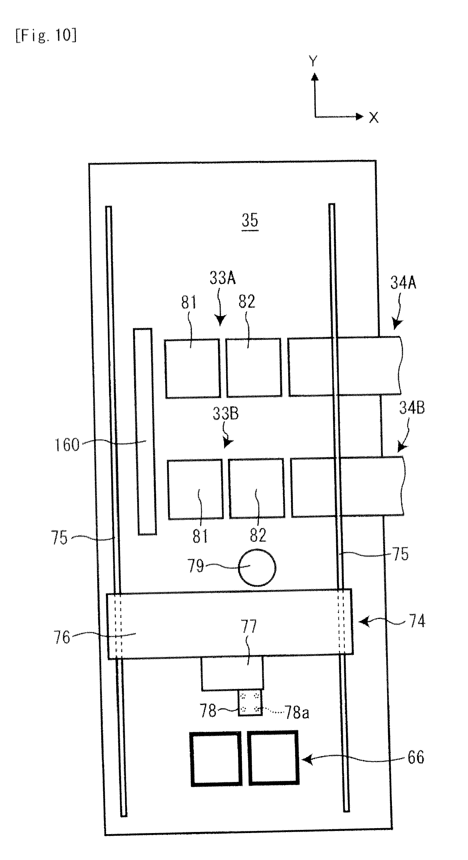

As shown in FIG. 10, work robot 74 for conveying photovoltaic cells 11 to each lower section hot plate 81 of number one and number two joining units 33A and 33B from cell transfer station 66 is arranged between cell transfer station 66 of number one and number two cell supply units 32A and 32B, and number one and number two joining units 33A and 33B. Work robot 74 is shared between number one and number two cell supply units 32A and 32B. Work robot 74 comprises Y slide 76 which is slidably guided along guide rails 75 provided in the Y direction, X slide 77 which is slidably guided along Y slide 76 in the X direction, and carrier head 78 which is attached movably in the up/down direction to X slide 77. Pickup hand 78a for picking up photovoltaic cells 11 is provided on carrier head 78. For stringing device 21 of the present embodiment, because work robot 74 is only for performing the operation of moving photovoltaic cells 11 from cell transfer station 66 onto lower section hot plate 81, only one carrier head 78 is attached.

An image of the pickup state of photovoltaic cells 11 conveyed to number one and number two joining units 33A and 33B from cell transfer station 66 by carrier head 78 is captured during conveyance by camera 79 and items such as the position deviation are corrected based on image recognition.

Number two cell supply unit 32B has the same configuration as the above number one cell supply unit 32A, and photovoltaic cells 11 are supplied into lower section hot plate 81 of number two joining unit 33B with flux 72 applied to the upper and lower surfaces of supplied photovoltaic cells which have the light receiving surface facing up.

As shown in FIG. 11, number one and number two joining units 33A and 33B each have fixed lower section plate 81 and movable upper section hot plate 82. Number one and number two joining units 33A and 33B are interposed by fixed block 83 which is arranged between number one and number two joining units 33A and 33B, and are arranged separated from each other in the Y direction by a predetermined amount, and are linked to each end (start section) of number one and number two cell conveyance unit 34A and 34B.

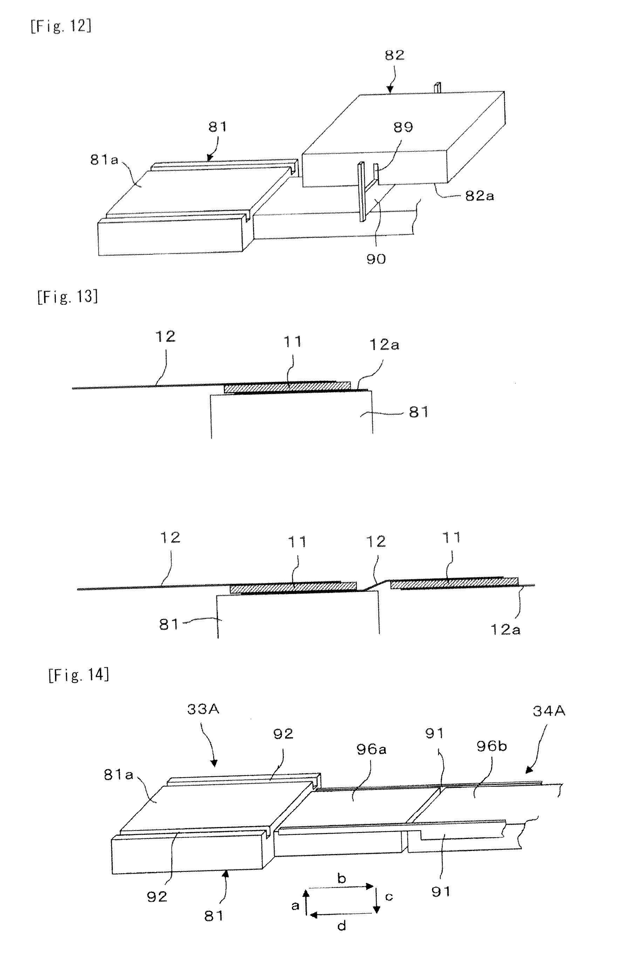

Because number one joining unit 33A and number two joining unit 33B have basically the same configuration, below the configuration of number one joining unit 33A is described based on FIG. 11 and FIG. 12.

A heater for pre-heating upper surface 81a of lower section hot plate 81 is embedded within lower section hot plate 81 of number one joining unit 33A, and a heater for heating lower surface 82a of upper section hot plate 82 is embedded within lower section hot plate 82.

On number one joining unit 33A, guide rail 84 is provided along the X direction in the side surface of fixed block 83 which is arranged on base 35. Moving platform 85 is guided movably in the X direction by a predetermined amount along guide rail 84 and upper section hot plate 82 is attached movably up/down by a predetermined amount on guide rail 86 which is provided on that moving platform 85.

Ball screw axis 88 moved by motor 87 is attached to fixed block 83 so that it is capable of being rotated around an axis line parallel to the X direction, and ball nut 85a fixed to moving platform 85 is engaged with that ball screw axis 88. The upper section hot plate 82 is positioned at the upper position of lower hot plate 81 by moving platform 85 being guided along guide rail 84 and moved a predetermined amount in the X direction by the rotation of ball screw axis 88. In that state, by lowering upper section hot plate 82 guided along guide 86 via a raising/lowering device omitted from the drawings, between lower section hot plate 81 and upper section hot plate 82, photovoltaic cell 11 and interconnectors 12 are pressed together while having heat applied.

As shown in FIG. 13, interconnectors 12 (12a) of a predetermined length supplied by number one connector supply unit 31A are loaded in multiple rows (two rows) on upper surface 81a of lower section hot plate 81. Also, photovoltaic cell 11 with flux 72 applied to the upper and lower surfaces is mounted on these interconnectors 12 so that flux 72 applied to the lower surface contacts interconnectors 12, and further, interconnectors 12 of a predetermined length are mounted in multiple rows (two rows) at a position contacting flux 72 applied to the upper surface of photovoltaic cell 11. In other words, photovoltaic cell 11 and interconnectors 12 on the upper and lower surfaces thereof are loaded on lower section hot plate 81 in a layered state.

In that state, by the lowering and X direction movement of upper section hot plate 82, interconnectors 12 and photovoltaic cell 11 are sandwiched between lower section hot plate 81 and upper section hot plate 82, and by pressing together interconnectors 12 and photovoltaic cells 11 while applying heat, interconnectors 12 are joined to the positive electrode and negative electrode of photovoltaic cell 11 via flux 72.

Guide groove 89 is formed along the Y direction on the central part in the X direction in lower surface 82a of upper section hot plate 82 of number one joining unit 33A. Retainer plate 90 acting as a retainer member is stored in guide groove 89 such that it can be protruded/retracted from/into lower surface 82a of upper section hot plate 82. Retainer plate 90 is pressed in the direction protruding from the lower surface of upper section top plate 82 by the biasing force of a spring omitted from the drawings, and is normally held in a position protruding by a predetermined amount from lower surface 82a of upper section hot plate 82.

By this, before pressing together with heat photovoltaic cell 11 and interconnectors 12 by lowering upper section hot plate 82, interconnectors 12 are pressed by retainer plate 90 and the spring force, so that the positional deviation between interconnectors 12 and photovoltaic cell 11 is reduced.

Also, retainer plate 90 is used to continue pressing interconnectors 12 with the spring force even after photovoltaic cell 11 and interconnectors 12 have been pressed together with heat and upper section hot plate 82 has been raised. By this, the positional deviation between photovoltaic cell 11 and interconnectors 12 is regulated for the time it takes for welded flux 72 to harden. As a result, interconnectors 12 can be joined to photovoltaic cell 11 accurately at a specified position.

Further, in FIG. 11, 160 is a duct, and by removing air from the area around joining units 33A and 33B via this duct 160, it functions as a smoke removal device which intakes smoke which occurs during the heat pressing.

Number two joining unit 33B is configured the same as the above number one joining unit 33A. A point that differs between number one joining unit 33A and number two joining unit 33B is that photovoltaic cells 11 are supplied to lower section hot plate 81 of number one joining unit 33A in an orientation with the light receiving surface facing down by number one cell supply unit 32A. In contrast, photovoltaic cells 11 are supplied to lower section hot plate 81 of number two joining unit 33B in an orientation with the light receiving surface facing up by number two cell supply unit 32B.

Number one cell conveyance unit 34A has an X direction length sufficient to simultaneously hold a predetermined amount Xm or greater of photovoltaic cells 11 conveyed onto lower section hot plate 81 of number one joining unit 33A. As shown in FIG. 14, number one cell conveyance unit 34A has a pair of conveyance members 91 which convey photovoltaic cells 11 joined with interconnectors 12.

Holding grooves 92 are provided in two rows along both sides in the X direction on the upper surface of lower section hot plate 81 such that these conveyance members 91 can be held within thereof Conveyance members 91 scoop up photovoltaic cells 11 over lower section hot plate 81 and convey them to the start end of number one cell supply unit 34A by the lift and carry operation of number one cell conveyance unit 34A, in other words, by the box movement of raising a --> forwarding b --> lowering c --> retracting d.

Conveyance members 91 are normally held in an origin position embedded within holding grooves 92, and when the joining of photovoltaic cell 11 and interconnectors 12 is completed, they are raised and photovoltaic cell 11 is scooped up. After that, photovoltaic cell 11 is conveyed one pitch and held on fixed support table which is omitted from the drawings of number one cell conveyance unit 34A by advancing and lowering conveyance members 91.

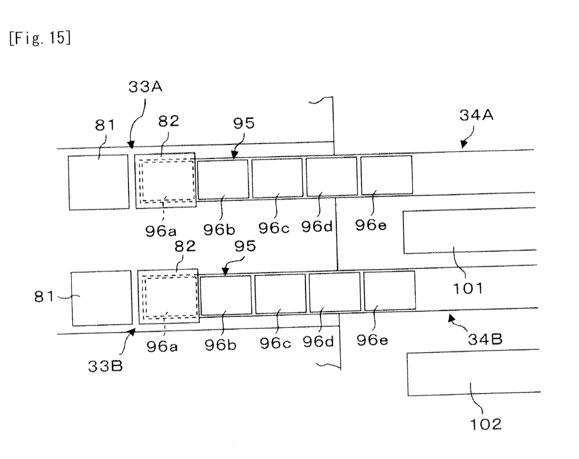

As shown in FIG. 15, slow cooling station 95 for slow cooling photovoltaic cells 11 conveyed by one pitch each from lower section hot plate 81 is provided at the start end of number one cell conveyance unit 34A.

Slow cooling station 95 comprises multiple slow cooling heaters 96a, 96b, 96c... arranged along the X direction at intervals of the conveyance pitch of photovoltaic cells 11. Multiple slow cooling heaters 96a, 96b, 96c... have the heater temperature set gradually lower in order to slowly and by levels lower the temperature of photovoltaic cells 11 conveyed from lower section hot plate 81, and the warping of photovoltaic cells 11 is reduced by the slow cooling.

For this, photovoltaic cell 11 conveyed from lower section hot plate 81 by number one cell conveyance unit 34A is first conveyed onto number one slow cooling heater 96a set to a predetermined temperature, and photovoltaic cell 11 heated by hot plates 81 and 82 is cooled to a predetermined temperature by number one slow cooling heater 96a. Continuing, photovoltaic cell 11 is conveyed onto and cooled by number two slow cooling heater 96b which is set to a lower predetermined temperature than number one slow cooling heater 96a, and is further conveyed onto and cooled by number three slow cooling heater 96b which is set to a lower predetermined temperature than number two slow cooling heater 96b.

In this way, photovoltaic cells 11 are slowly cooled in levels by slow cooling station 95 comprising three to five slow cooling heaters 96a, 96b, 96c... and warping of photovoltaic cells 11 due to sudden lowering of temperature is reduced. The slow cooling means for slow cooling photovoltaic cells 11 is slow cooling station 95 which comprises these multiple slow cooling heaters 96a, 96b, 96c...

Number two cell conveyance unit 34B has the configuration as the above number one cell conveyance unit 34A, a difference being whether photovoltaic cells 11 are conveyed with the light receiving surface facing down or facing up.

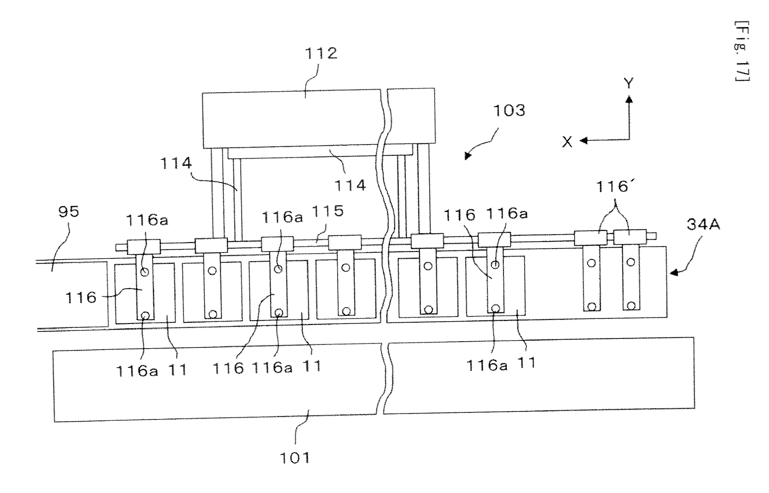

As shown in FIG. 16 and FIG. 17, number one cell stand 101 and moving device 103 are arranged on each side of number one cell conveyance unit 34A. Moving device 103 is an item for moving number one photovoltaic group 110A made from a predetermined quantity of photovoltaic cells 11 conveyed by number one cell conveyance unit 34A onto number one cell stand 101.

Moving device 103 comprises moving platform 112 movably guided along guide rail 111 provided in the Y direction on base 35, raising/lowering platform 114 attached to be movable up and down on guide rail 113 which is formed in the up/down direction in moving platform 112, and multiple pickup heads 116 attached to be adjustable in the X direction to holding rail 115 which is attached on raising/lowering platform 114. A quantity of pickup heads 116 is provided that can pick up at least each of the predetermined quantity (Xm) of photovoltaic cells 11 which make up number one photovoltaic cell group 110A, and a pair of pickup hands 116a are respectively attached to these pickup heads 116 to pick up the upper surface of photovoltaic cells 11.

In order to support different types of photovoltaic modules 10, the present embodiment is provided with only "a" (2) excess pickup heads 116 are provided, and usually excess pickup heads 116' are retracted to a position so as not to obstruct the pickup of number one photovoltaic cell group 110A.

Pickup hands 116a respectively contact the upper surface of each photovoltaic cell 11 on number one cell conveyance unit 34A by the lowering of raising/lowering platform 114 and pick up each photovoltaic cell 11 simultaneously by vacuum pickup. Further, number one photovoltaic cell group 110A picked up by pickup hands 116a are moved onto number one cell stand 101 by the raising of raising/lowering platform 114 and the advancing of moving platform 112.

As shown in FIG. 16, number two cell stand 102 is provided next to number two cell conveyance unit 34B and inverting/moving device 104 is provided between number two cell stand 102 and number two cell conveyance unit 34B. Inverting/moving device 104 is an item for inverting and transferring number two photovoltaic group 110B made from a predetermined quantity of photovoltaic cells 11 conveyed by number two cell conveyance unit 34A onto number two cell stand 102.

Inverting/moving device 104 comprises inverting stand 122 which is attached rotatably around spindle 121 which is parallel in the X direction above base 35, inversion moving device 124 with a power source of motor 123 which inverts this inverting stand 122 by 180 degrees, slider 125 which is attached to inverting stand 122 such that it can be slid a predetermined amount, and multiple pickup heads 126 attached to be adjustable in the X direction on slider 125.

In the same way as for pickup heads 116 of moving device 103 above, "Xm + a" pickup heads 126 are provided, and a pair of pickup hands 126a are respectively attached to these pickup heads 126 to pick up the lower surface of a predetermined quantity of photovoltaic cells 11 which make up number two photovoltaic cell group 110B.

Pickup hands 126a contact the lower surface of each photovoltaic cell 11 on number two cell conveyance unit 34B by the sliding of slider 125 and pick up each photovoltaic cell 11 simultaneously by vacuum pickup. Further, number two photovoltaic cell group 110B picked up by pickup hands 126a are loaded in an inverted state onto number two cell stand 102 by the 180 degree inversion of inverting stand 122.

In other words, inverting/moving device 104 loads number two photovoltaic cell group 110B onto number two cell stand 102 after inverting them to be oriented with the light receiving surface facing down. By this, the light receiving surfaces of number one and number two photovoltaic cell groups 110A and 110B loaded onto number one and number two cell stands 101 and 102 are arranged in the same way facing down.

Layup device 22 is provided with respect to number one and number two cell stands 101 and 102 of stringing device 21. As shown in FIG. 4, cover glass 130 for arranging photovoltaic cell groups 110A and 110B in a predetermined quantity of rows in the Y axis direction is supplied automatically or manually from holding position P1 to layup device 22. Number one and number two photovoltaic cell groups 110A and 110B are conveyed to and laid up on cover glass 130 alternately from number one and number two cell stands 101 and 102.

For this, a pair of guide rails 131 are provided on layup device 22 along the Y direction across and above number one and number two cell stands 101 and 102, and carrier head 132 for conveying photovoltaic cell groups 110A and 110B is attached movably in the Y direction to guide rails 131. Raising/lowering stand 133 is attached to carrier head 132 such that it can be raised/lowered.

Although not shown in the drawings, in the same way as for moving device 103 above, a support rail is attached to raising/lowering stand 133, and multiple (Xm + a) pickup heads are attached to this support rail to be adjustable in the X direction. Pairs of pickup hands for respectively picking up the upper surface of the predetermined quantity of photovoltaic cells 11 which make up photovoltaic cell groups 110A and 110B are attached to the pickup heads.

The pickup hands respectively contact the upper surface of each photovoltaic cell 11 of photovoltaic cell groups 110A and 110B which are moved onto number one or number two cell stand 101 and 102 by the lowering of raising/lowering stand 133 and pick up each photovoltaic cell 11 simultaneously by vacuum pickup. Further, photovoltaic cell groups 110A and 110B which have been picked up are conveyed above cover glass 130 supplied to layup device 22 by the raising of raising/lowering platform 133 and the Y direction movement of carrier head 132, and photovoltaic cell groups 110A and 110B are mounted onto cover glass 130 by the lowering of raising/lowering platform 133. Here, number one photovoltaic cell group 110A conveyed from number one cell stand 101 and number two photovoltaic cell group 110B conveyed from number two cell stand 102 are mounted on cover glass 130 alternately in the Y direction.

When just the predetermined quantity of rows (Yn) of photovoltaic cell groups 110A and 110B have been mounted in the Y direction on cover glass 130, cover glass 130 is conveyed via conveyor 25 to matrixing device 23.

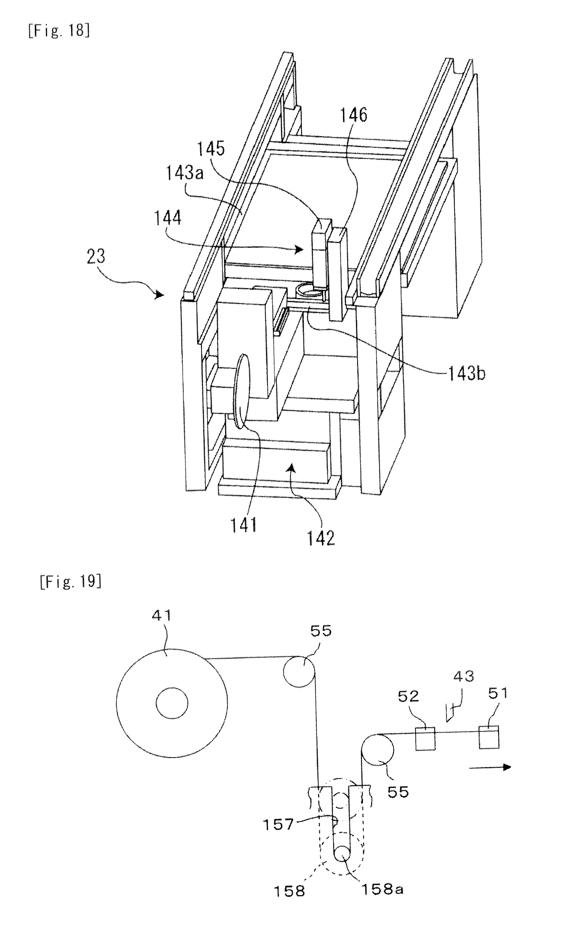

As shown in FIG. 18, matrixing device 23 comprises busbar supply unit (conductive member supply unit) 142 which supplies busbars 14 (refer to FIG. 1) which act as a conductive member and are wound around bobbin 141, and work robot 144 which is movable in the X and Y directions along guide rails 143a and 143b.

Busbar supply unit 142 pulls out in the Y direction busbars 14 which are wound around bobbin 141, cuts them to a predetermined length, and supplies the cut busbars 14 to a predetermined position. Carrier head 145 provided with a pickup member for picking up busbar 14 which has been cut to a predetermined length and processing head 146 with heater for welding busbar 14 embedded within are attached movably in the up/down direction to work robot 144.

Further, when cover glass 130 is conveyed from layup device 22 to a predetermined position by conveyor 25, busbars 14 supplied to a predetermined position by busbar supply unit 142 are mounted in order across the ends of interconnectors 12 protruding from the right end of each of number one and number two photovoltaic cell groups 110A and 110B which are next to each other in the Y direction by carrier head 145 of work robot 144. Thereafter, busbar 14 is welded and busbar 14 and interconnectors 12 are connected electrically by processing head 146 of work robot 144.

When matrixing is complete for the right end of photovoltaic cell groups 110A and 110B, cover glass 130 is conveyed a predetermined amount by conveyor 25, and then in that state, in the same way as above, as well as mounting in order busbar 14 across interconnectors 12 protruding from the left end of each of number two and number one photovoltaic cell groups 110B and 110A which are next to each other in the Y direction, busbar 14 is welded and busbar 14 and interconnectors 12 connected electrically. By this, all of the Xm x Yn photovoltaic cells 11 which have been matrixed are electrically connected in series.

Here, instead of busbar 14, an interconnector may be used and this interconnector joined to the above interconnectors 12 via flux.

Next, a stringing method for photovoltaic cells 11 and a method for manufacturing photovoltaic modules 10 by combing strung photovoltaic cell groups 110A and 110B based on the above embodiment are described.

First, in the original state shown in FIG. 6 (A) in which the ends of interconnectors 12 pulled out from each bobbin 41 of number one and number two connector supply units 31A and 31 B are clamped by number one clamper 51, number two ball screw axis 48 is rotated a predetermined amount by number two motor 49 and, as shown in FIG. 6 (B), number one clamper 51 is moved to the forward position and interconnectors 12 are pulled to a predetermined position. In that state, cutter 43 is lowered and interconnectors 12 are cut to a predetermined length.

Next, number one ball screw axis 47 is rotated a predetermined amount by number one motor 46 and, as shown in FIG. 6 (C), number one clamper 51 and moving guide 50 are moved as one with moving platform 45. By this, number one clamper 51 is moved above lower section hot plate 81, and the predetermined length of interconnectors 12 which are clamped by this are supplied onto photovoltaic cell 11 loaded on lower hot plate 81. Conversely, number two clamper 52 is unclamped and retracted a specified amount.

Next, number two clamper 52 is advanced a specified amount with interconnectors 12 clamped, and interconnectors 12 are pulled to cutter 43 front position (refer to FIG. 6 (D)). At the same time, number one clamper 51 is unclamped and, along with moving platform 45, number one clamper 51 is returned to its original position by number one and number two motors 46 and 49 (refer to FIG. 6 (A)).

Here, two types of interconnectors 12 are cut, short ones of a length to be joined to photovoltaic cells 11 at each end of photovoltaic cell groups 110A and 110B, and long ones of a length to join adjacent photovoltaic cells 11 to each other. In other words, when joining interconnectors 12 to the first photovoltaic cell 11 of photovoltaic cell groups 110A and 110B, first, short interconnectors 12 are supplied in two rows each to a specified position above each lower section hot plate 81 of number 11 and number 2 joining units 33A and 33B.

Next, photovoltaic cell 11 supplied first with its light receiving surface facing down by number one cell supply unit 32A, with flux 72 having been applied to both its upper and lower surfaces, is supplied onto interconnectors 12 on lower section hot plate 81 of number one joining unit 33A. At the same time, photovoltaic cell 11 supplied first with its light receiving surface facing up by number two cell supply unit 32B, with flux 72 having been applied to both its upper and lower surfaces, is loaded onto interconnectors 12 on lower section hot plate 81 of number two joining unit 33B.

Thereafter, the front half of long interconnectors 12 is supplied respectively to photovoltaic cell 11 with its light receiving surface facing down and photovoltaic cell 11 with its light receiving surface facing up. As a result of this, as shown in FIG. 13(A), photovoltaic cell 11 and interconnectors 12 are loaded on each lower section hot plate 81 of number one and number two joining units 33A and 33B in a layered state.

Here, by interconnectors 12 being pulled out at a predetermined acceleration by number one clamper 51 of pulling out means 42 while they are in a state being drawn with a pulling force smaller than that required to break them, the winding curl of interconnectors 12 with winding curl which are wound around bobbin 41 is removed and corrected to be straight.

Next, by the lowering and X direction movement of upper section hot plate 82, interconnectors 12 and photovoltaic cell 11 are sandwiched between lower section hot plate 81 and upper section hot plate 82, and by pressing together interconnectors 12 and photovoltaic cells 11 while applying heat, interconnectors 12 are joined to the positive electrode and negative electrode of photovoltaic cell 11 via flux 72.

Here, by the lowering of upper section hot plate 82, retainer plate 90 shown in FIG. 12 presses against interconnectors 12 on photovoltaic cell 11 from above with the spring force, so the positional deviation between interconnectors 12 and photovoltaic cell 11 layered on each other can be reduced.

Thereafter, as well as each upper section hot plate 82 being raised, they are moved a predetermined amount in the X direction and retracted from above lower section hot plate 81. By this, interconnectors 12 are joined via flux 72 to the upper and lower surfaces of photovoltaic cell 11.

Here, because retainer plate 90 continues to press against interconnectors 12 by the spring force even when upper section hot plate 82 is raised, while welded flux 72 is hardening, the positional deviation between photovoltaic cell 11 and interconnectors 12 is regulated.

Photovoltaic cell 11 to which interconnectors 12 have been joined are scooped up by conveyance members 91 and conveyed by one pitch each by the lift and carry operation of number one and number two cell conveyance units 34A and 34B. By this, the first photovoltaic cell 11 is conveyed from lower section hot plate 81 onto number one slow cooling heater 96a and slow cooled. By this one pitch conveyance, the latter half of interconnectors 12 joined to the upper surface of photovoltaic cell 11 is positioned above lower section hot plate 81.

Next, the second photovoltaic cell 11, in the same way as above, is supplied onto lower section hot plate 81 with flux 72 having been applied by number one and number two cell supply unit 32A and 32B and is loaded onto the latter half of interconnectors 12 positioned on lower section hot plate 81.

Then, long interconnectors 12, in the same way as above, are supplied onto lower section hot plate 81 by number one and number two connector supply units 31 A and 31 B and the front half thereof is layered (refer to FIG. 13(B)) on photovoltaic cell 11. In that state, upper section hot plate 82 is operated and interconnectors 12 are joined via flux 72 to the upper and lower surfaces of photovoltaic cell 11.

Thereafter, by the lift and carry operation of number one and number two cell conveyance units 34A and 34B, at the same time as the first photovoltaic cell 11 being conveyed from number one slow cooling hit 96a to number two slow cooling heater 96b, the second photovoltaic cell 11 is conveyed from lower section hot plate 81 to number one slow cooling heater 96a.

By repeating operation in this way, photovoltaic cells 11 to which interconnectors 12 have been joined are conveyed in order by one pitch each by number one and number two cell conveyance units 34A and 34B. As a result, number one and number two photovoltaic cell groups 110A and 110B made from a predetermined quantity of photovoltaic cells 11 are conveyed on number one and number two cell conveyance units 34A and 34B.

In this way, because number one and number two photovoltaic cell groups 110A and 110B can be manufactured by the same joining process (refer to FIG. 13) for building up in order from below interconnectors 12, photovoltaic cells 11 and interconnectors 12, the work of stringing photovoltaic cell groups 110A and 110B can be performed easily.

Further, for the interconnectors to be joined to the last photovoltaic cell 11 of number one and number two photovoltaic cell groups 110A and 110B too, short ones are used, and short interconnectors 12a are joined to the reverse surface (upper surface) of photovoltaic cell 11 by number one joining unit 33A and short interconnectors 12a are joined to the light receiving surface (upper surface) of photovoltaic cell 11 by number two joining unit 33B.

When photovoltaic cell groups 110A and 110B made from the required quantity of photovoltaic cells 11 are conveyed onto number one and number two cell conveyance units 34A and 34B respectively, the next photovoltaic cell groups 110A and 110B should be manufactured on number one and number two joining units 33A and 33B, and the above operation is repeated once again with the first photovoltaic cell 11 being supplied at the same time as short interconnectors 12 being supplied.

By doing this, when the last photovoltaic cells 11 of photovoltaic cell groups 110A and 110B conveyed onto number one and number two cell conveyance unit 34A and 34B pass through slow cooling station 95, the upper surfaces of each photovoltaic cell 11 of number one photovoltaic cell group 110A on number one cell conveyance unit 34A are picked up by multiple pickup heads 116 of moving device 103 respectively, and are moved onto number one cell stand 101 by moving device 103 with their light receiving surface (negative electrode) facing down without changing their orientation. In other words, number one photovoltaic cell group 110A, as shown in FIG. 2, is moved onto number one cell stand 101 in a state in which short interconnectors 12a joined to the negative electrode of the first photovoltaic cell 11 are in a position under photovoltaic cell 11.

In the same way, the lower surfaces of each photovoltaic cell 11 of number two photovoltaic cell group 110B on number two cell conveyance unit 34B are picked up by multiple pickup hands 126a of inverting/moving device 104 respectively, and number two photovoltaic cell group 110B are inverted by the 180 degree inversion operation of inverting stand 122, and moving onto number two cell stand 102 in a state with the light receiving surface (negative electrode) facing down. In other words, number two photovoltaic cell group 110B, as shown in FIG. 3, is moved onto number two cell stand 102 in a state in which short interconnectors 12a joined to the positive electrode of the first photovoltaic cell 11 are in a position on top of photovoltaic cell 11.

As a result, number one and number two photovoltaic cell groups 110A and 110B moved respectively to number one and number two cell stands 101 and 102 are both oriented with their light receiving surface facing down, and for number one and two photovoltaic cell groups 110A and 110B which are arranged in the same direction, as shown in FIG. 2 and FIG. 3, the connection construction of interconnectors 12 with respect to photovoltaic cell 11 is alternately different.

In this way, number one and number two photovoltaic cell groups 110A and 110B conveyed onto number one and number two cell conveyance units 34A and 34B are conveyed onto number one and number two cell stands 101 and 102 by moving device 103 and inverting/moving device 104. By this, it is no longer necessary to keep more than necessary photovoltaic cells 11 on number one and number two cell conveyance units 34A and 34B, the above joining work and conveyance work can be continued, and stringing work can be performed efficiently.

Conversely, cover glass 130 for arranging two types of photovoltaic cell groups 110A and 110B in a predetermined quantity of rows alternately in the Y axis direction is supplied automatically or manually to the layup position of layup device 22, and photovoltaic cell groups 110A and 110B are conveyed alternately from number one and number two cell stands 101 and 102 onto this cover glass 130 by carrier head 132.

In other words, number one photovoltaic cell group 110A is mounted onto the first row of cover glass 130 from number one cell stand 101, and number two photovoltaic cell group 110B is mounted onto the second row of cover glass 130 from number two cell stand 102. Thereafter, number one photovoltaic cell groups 110A are mounted onto the odd number rows of cover glass 130 and number two photovoltaic cell groups 110B are mounted onto the even number rows of cover glass 130, and the required quantity of rows of photovoltaic cell groups 110A and 110B are arranged in the Y axis direction. By this, short interconnectors 12a joined to the negative electrode of photovoltaic cells 11 and short interconnectors 12a joined to the positive electrode of photovoltaic cells 11 are arranged alternating in the Y axis direction at both ends of photovoltaic cell groups 110A and 110B adjacent in the Y axis direction.

When Yn rows of photovoltaic cell groups 110A and 110B made from Xm strung photovoltaic cells 11 are mounted in the Y direction on cover glass 130, cover glass 130 is conveyed from layup device 22 to matrixing device 23 by conveyor 25.

When the front section (the right section in FIG. 4) of cover glass 130 is conveyed inside matrixing device 23, busbar 14 cut to a specified length is mounted between interconnectors 12a connected to the negative electrode protruding from the right end of the first row of photovoltaic cell group 110A and interconnectors 12a connected to the positive electrode protruding from the right end of the second row of photovoltaic cell group 110B.

The busbar 14 in question is pulled out in the Y direction from bobbin 141 of busbar supply unit 142 of matrixing device 23 and cut to a specified length, picked up and held by the pickup heads attached to carrier head 145 of work robot 144, and mounted between interconnectors 12a.

In the same way, busbars 14 are respectively mounted between interconnectors 12a protruding from the right ends of the third and fourth rows of photovoltaic cell groups 110A and 110B, and interconnectors 12a protruding from the right ends of the fifth and sixth rows of photovoltaic cell groups 110A and 110B.

In such a state, by pressing together while applying heat to the connection points between busbar 14 and interconnectors 12 using a heater embedded in processing head 146, busbar 14 is melted and interconnectors 12a joined to the negative electrode and interconnectors 12a joined to the positive electrode are electrically connected via busbar 14.

Next, cover glass 130 is conveyed a predetermined amount in the X direction, and when rear section (the left section in FIG. 4) of cover glass 130 is conveyed inside matrixing device 23, in the same way as above, busbar 14 cut to a specified length is mounted between interconnectors 12a connected to the negative electrode protruding from the left end of the second (fourth) row of photovoltaic cell group 110B and interconnectors 12a connected to the positive electrode protruding from the left end of the third (fifth) row of photovoltaic cell group 110A. And, by melting busbar 14 using processing head 146, interconnectors 12a joined to the negative electrode and interconnectors 12a joined to the positive electrode are electrically connected via busbar 14.

In this way, all of Xm x Yn photovoltaic cells 11 are connected electrically in series via interconnectors 12 and busbars 14 and thus photovoltaic module 10 is manufactured. After that, the photovoltaic module 10 is conveyed to conveyor 26 and conveyed to the next process. And, in the next process, as well as the top of photovoltaic cells 11 being sealed with a resin such as EVA and a back sheet being mounted, the completed product is made by covering the circumference with an airtight aluminium frame.

FIG. 19 shows an alternative embodiment of the present invention; in the above embodiment interconnectors 12 pulled out from bobbin 41 were drawn by a drawing means comprising tension cylinder 58; however, in the alternative embodiment shown in FIG. 19, the winding curl of interconnectors 12 is removed by drawing means comprising spindle 158 which is capable moving up/down and which has a mass corresponding to a force smaller than that required to break interconnector 12.

In other words, as shown in FIG. 19, in a position below and between multiple guide rollers 55, axis sections 158a provided at both ends of spindle 158 are guided while capable of moving in the up/down direction along guide groove 157. Interconnectors 12 are passed along and bent into a U shape on spindle 158 and guided to fixed number two clamper 52. In this case, a spindle 158 with around 80% of the mass with respect to the force required to break interconnector 12 is suitable.

Further, by pulling out one end of interconnector 12 clamped in number one clamper 51 using motor 59 (refer to FIG. 5), for example, horizontally at an acceleration of 1G, interconnector 12 can be drawn against the pulling force by spindle 158. By this, in the same way as describe in the previous embodiment, the winding curl of interconnectors 12 with winding curl which are wound around bobbin can be removed and corrected to be straight.

The above embodiment comprises: pulling out means 42 for clamping and pulling out one end of conductive member (interconnector) 12 wound around bobbin 41; a drawing means comprising such as spindle 158 or tension cylinder 58 which draws conductive members 12 with a force smaller than that required to break them; and moving means (motor) 46 for moving pulling out means 42 which clamped an end of conductive member 12 at a predetermined acceleration and pulling conductive member 12 against the drawing means (58, 158).

With this configuration, by an extremely simple configuration which just pulls conductive member 12 wound around bobbin 41 at a predetermined acceleration, the winding curl of conductive member 12 can be removed and corrected to be straight and photovoltaic cell 11 and conductive member 12 can be joined accurately.

According to the above embodiment, because the drawing means comprises spindle 158 which is capable of moving up/down and which has a mass corresponding to a force smaller than that required to break conductive member 12, the winding curl of conductive member 12 can be removed by a simple configuration just by providing spindle 158.

In the above embodiment, conductive members (interconnectors) 12 are joined to each electrode of photovoltaic cells 11 via flux 72, but conductive members coated with solder can also be used as conductive members 12, in which case applying flux is not required.

Also, in the above embodiment, an example was given in which multiple conductive members 12 and photovoltaic cells 11 were joined simultaneously by being heat pressed between lower section hot plate 81 and upper section hot plate 82, but this can also be performed by attaching a heater to an item such as a robot capable of moving in three dimensions.

In such ways, the present invention is not limited to the configurations provided in the embodiment and there are various possible embodiments which do not extend beyond the range of the object of the present invention as given in the claims. Industrial Applicability

The conductive member winding curl removal device and removal method of the present invention are suitable for use with photovoltaic modules in which adjacent photovoltaic cells are joined electrically via conductive members.

### Symbol descriptions

10: Photovoltaic module; 11 (11A, 11B): Photovoltaic cell; 12, 14: Conductive member (interconnector, busbar); 21: Stringing device; 31A, 31B: Conductive member supply unit; 32A, 32B: Cell supply unit; 33A, 33B: Joining unit; 34A, 34B: Cell conveyance unit; 42: Pulling out mean; 58, 158: Drawing means (tension cylinder, spindle); 46: Moving means (motor)

## Claims

1. For a conductive member supply device which has a bobbin around which is wound a conductive member which connects adjacent photovoltaic cells electrically and which, as well as pulling out an end of the conductive member wound around the bobbin and supplying it to a predetermined position, cuts the conductive member to a predetermined length; a conductive member winding curl removal device comprising: a pulling out means for clamping the end of and pulling out the conductive member wound around the bobbin; a drawing means for drawing the conductive member with a force smaller than the force required to break the conductive member arranged between the pulling out means and the bobbin; and a moving means for moving the pulling out means which clamped the end of the conductive member at a predetermined acceleration and pulling the conductive member against the drawing means.

2. The conductive member winding curl removal device according to claim 1 in which the drawing means comprises a spindle which is capable of moving up/down and which has a mass corresponding to a force smaller than that required to break the conductive member.

3. For a conductive member supply device which has a bobbin around which is wound a conductive member which connects adjacent photovoltaic cells electrically and which, as well as pulling out an end of the conductive member wound around the bobbin and supplying it to a predetermined position, cuts the conductive member to a predetermined length; a conductive member winding curl removal method in which: the winding curl of the conductive member is removed by the conductive member being pulled out from the bobbin and drawn with a force smaller than the force required to break the conductive member and pulling an end of the conductive member at a predetermined acceleration.
